# EUROPEAN PATENT APPLICATION

(11) **EP 3 644 030 A1**
(43) Date of publication of application: **29.04.2020**
(21) Application number: 18201986.9
(22) Date of filing: 23.10.2018
(51) Int. Cl.: G01J 3/02, G01J 3/10, G01J 3/42, G01N 21/3504, G01N 21/35, G01N 21/39, H01S 5/40

(54) **COLLIMATION OF MULTIPLE MONOCHROMATIC LIGHT SOURCES**

(71) Applicant: Siemens Aktiengesellschaft, 80333 München (DE)
(72) Inventor: Strzoda, Rainer, 81825 München (DE); Hangauer, Andreas, 80634 München (DE); Heinrich, Robert, 81737 München (DE); Popescu, Alexandru, 81673 München (DE)

(57) **Abstract**

The present invention provides an optical system and a method for operating a module containing an array (2) with at least two independently switchable monochromatic light sources (3, 4) and a collimation device (5) with an off-axis parabolic mirror (6), for example as part of a tuneable laser spectrometer (14).

The advantage of the invention lies in collimating the beams of different monochromatic light sources (3 and 4) on a common beam axis.

## Description

### Field of the Invention

The present invention relates to an optical system, a spectrometer, and a method for collimation of multiple monochromatic light sources. The monochromatic light sources can be designed as a laser array.

### Background of the Invention

The collimation of monochromatic light sources is important in spectroscopy, for example. For widely tuneable laser spectrometers two regimes are known. On the one hand, there are instruments, which cover a continuous wavelength band as in the case of the hydrocarbon measurement. In this case the absorption features are broad and can be accessed only by lasers covering the wavelength band without gap. This is realized most economically with a monolithic laser array.

On the other hand, there are applications which require the combination of narrow detection bands at quite different wavelengths in the infrared. E.g. the monitoring of combustion processes requires accessing CO₂, CO, SO₂, NO, NO₂, H₂O and O₂ which absorb in the 4, 5, 6 µm regime, O₂ even in the visible at 0.76 µm. This range cannot be covered with a single integrated beam combiner (= collimation device). In this case the laser array consists of individual laser chips placed in an array manner. For e.g. spectroscopic applications the collimation of the laser beams from the laser arrays and the superposition of the beams from all lasers on a common beam axis are required.

In literature several approaches have been proposed which solve the problem only partly. Using micro lens arrays fulfil the task of collimating the different laser beams, but do not superimpose them on a common axis.

Using a micro lens array in combination with a grating leads to beam steering when the laser wavelength is modulated, as introduced by Lee et al. (BG Lee, J Kansky, AK Goyal, C Pflugl, L Diehl, MA Belkin, A Sanchez, F Capasso. Beam combining of quantum cascade laser arrays. Optics Express (2009) 17(18): 16216-16224 and the published patent application US 2012/0033697 A1).

Using Arrayed Waveguide Gratings or Planar Concave Gratings as introduced by Jiang et al. solves the problem in principle needs for every set of wavelengths a specific design (G Jiang, S Baig, H Lu, K Shen, MR Wang. Planar concave grating wavelength demultiplexers with flattened spectral response based on SU-8 polymer waveguides. Optical Engineering (2016) 55(3): 037104*).* This, however, has the disadvantage that any two parallel optical surfaces (windows, lenses in the centre, cavities between laser chip and the window of the housing...) in the laser beam produce residual interference patterns visible as a wavelength dependent modulation superimposed on the laser signal.

The absorbance resolution for industry-grade Tuneable Diode Laser Absorption Spectroscopy (TDLAS) is in the order of 10⁻⁶ with respect to the electronics. Residual interference patterns typically limit the resolution to values in the 10⁻⁵ range. Any means of beam combining has to meet this requirement finally which cannot be achieved easily as additional optical elements have to be introduced in the optical beam.

Another aspect is the back reflection from the combiner chip facets into the laser cavity which disturbs the laser operation and gives raise to excess noise. To avoid this, the reflectivity of the facets has to be as low as possible. Therefore an extra antireflection-coating step has to be introduced into the fabrication of an integrated laser module.

### Summary of the Invention

The objective of the present invention is to provide a solution for an improved collimation of multiple monochromatic light sources, for example of lasers of a laser array.

To accomplish the objective, the present invention provides an optical system, a spectrometer, and a method for operating the optical system according to the independent claims. Advantageous embodiments are provided in the dependent claims.

According to the invention, independently emitted monochromatic light beams are collimated by an collimation device, which is moved along the facets of the emitting monochromatic light sources.

The invention claims an optical system, which comprises at least two independently switchable monochromatic light sources and a collimation device. The collimation device moves its focus into the light output facet of the currently active and switched on monochromatic light source.

According to a further embodiment the collimation device comprises an off-axis parabolic mirror. The off-axis parabolic mirror is used as means of collimation.

The advantage of the invention is to enable collimating the beams of different monochromatic light sources on a common beam axis. The design with the movable collimation device with the mirror is wavelength independent. It conserves the quality of each individual beam, especially regarding pointing stability and noise on the laser signal. The solution avoids additional optical elements passed by light beams, which may give raise to interference fringe creation, which leads to an unwanted modulation of the light intensity as a function of the wavelength. Even more severe is the case when the optical element reflects a fraction of the light intensity back into the light output source which leads to excess noise on the output power.

According to a further embodiment the monochromatic light sources are further switchable in a timely consecutive way. This, in combination with the in front of each light source movable collimation device allows operating each light source individually, what means providing the optimum operating conditions regarding stability and noise.

In a further embodiment of the invention the monochromatic light sources can form a laser array. This has the advantage of arranging multiple lasers.

In a further embodiment of the invention the collimation device is movable by a linear translation stage. The advantage is a smooth and exact movement of the collimation device.

According to the present invention the inventively optical system can be used in a tuneable laser spectrometer, whereas the wavelength of the laser is in the infrared range. This has the advantage that therefore, the invention allows to build for example laser-based multi-gas analysers deploying laser arrays for wide wavelength coverage.

The present invention further claims a method for operating an inventively optical system as described previously, which moves the collimation device along the light output facets of the monochromatic light sources. This means the collimation device is moved on linear stage parallel to the facets of the monochromatic light sources. The method further includes a timely consecutive emission of the monochromatic light sources. The movement of the collimation device is synchronized timely with the consecutive emission of the monochromatic light sources.

The advantage of the invention is that with respect to noise, the interference issues and back reflection into the laser the presented invention provides the optimum operating conditions for the laser array as each laser is operated in the same way as in single laser spectrometer.

Further benefits and advantages of the present invention will become apparent after a careful reading of the detailed description with appropriate reference to the accompanying drawings.

### Brief Description of the Drawings

- Fig. 1: shows a side view of an optical system with an array monochromatic light sources and a movable collimation device with an off-axis parabolic mirror, while the first monochromatic light source is used,
- Fig. 2: shows a side view of an optical system with an array monochromatic light sources and a movable collimation device with an off-axis parabolic mirror, while the fourth monochromatic light source is used,
- Fig. 3: shows a sectional view of an off-axis parabolic mirror and,
- Fig. 4: shows a block diagram of a tuneable laser spectrometer.

### Detailed Description of the Invention

As an example for a means of collimation of the collimation device 5 the examples in the following figures show an off-axis parabolic mirror 6.

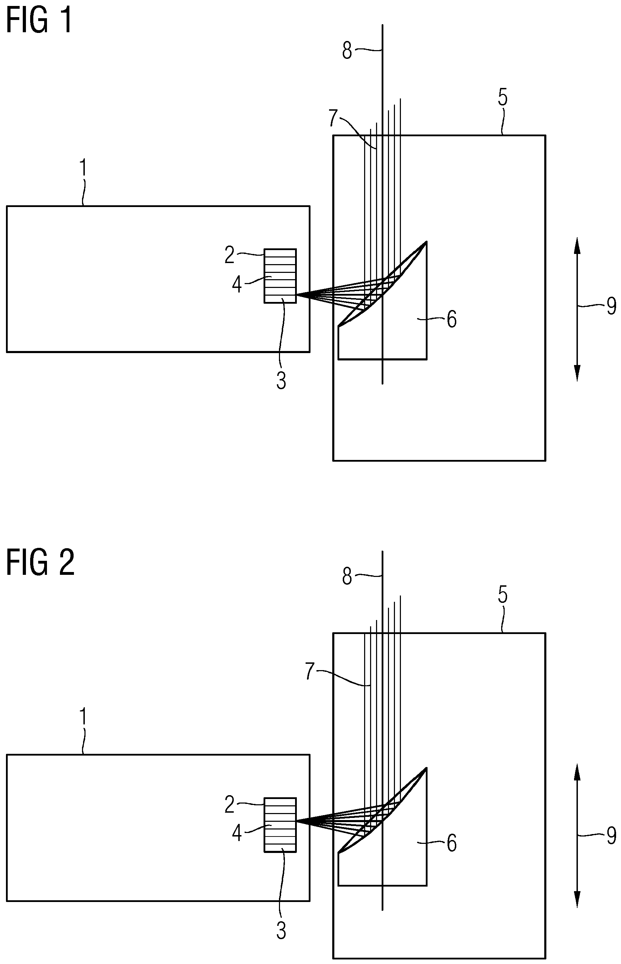

Fig. 1 and Fig. 2 show the working principle of the optical system containing a monochromatic light source module 1 and a collimation device 5. The collimation device 5 contains an off-axis parabolic mirror 6, which works as a beam reflecting and collimating surface. The monochromatic light source module 1 contains an array of monochromatic light sources 2 with at least two elements which are switchable independently in a timely consecutive way. The monochromatic light sources can be for example laser elements of a laser array.

The collimation device 5 is movable along the array of monochromatic light sources 2 meaning that the collimation device 5 moves on linear stage parallel to the array of monochromatic light sources 2, which is indicated by the direction of off-axis parabolic mirror displacement 9 of the off-axis parabolic mirror 6.

The collimation device 5 carries the off-axis parabolic mirror 6 in such a way that it is always placed in front of a monochromatic light source element (for example the first monochromatic light source 3 as shown in Fig. 1 or the fourth monochromatic light source element 4 as shown in Fig. 2) with the monochromatic light source output facet in the focus distance of the off-axis parabolic mirror 6.

In Fig. 1 the first monochromatic light source 3 is active and switched on, while in Fig. 2 the fourth monochromatic light source 4 is active and switched on. The output of the off-axis parabolic mirror 6 is then a collimated monochromatic light beam 7. Moving the collimation device 2 along its cylinder axis of the off-axis parabolic mirror 6 each monochromatic light source in the array of monochromatic light sources 2 can be collimated along a common monochromatic light beam axis 8. This allows using all monochromatic light sources in the array of monochromatic light sources 2 for e.g. a spectroscopic measurement in a timely consecutive way.

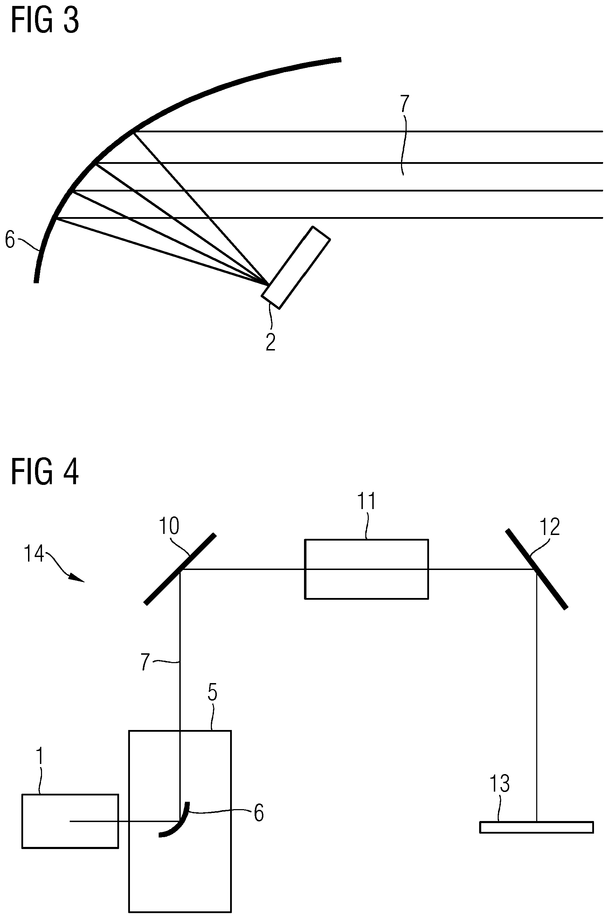

Fig. 3 shows an array of monochromatic light sources 2 emitting on an off-axis parabolic mirror 6, which reflects a collimated monochromatic light beam 7.

A parabolic mirror takes light from a point source located at the focus and creates a collimated beam. In other words, a source with spherical wavefronts placed at the parabolic focus is converted into a beam with plane wavefronts. On the other hand, plane wavefronts incident on the parabolic mirror are focused at the focal point. Therefore, the single surface of a parabolic mirror can produce a diffraction limited image without chromatic effects.

A complete parabolic mirror would focus a collimated beam at its focal point, which is often not useful because it overlaps with part of the incoming beam. Accessing the focal point can be difficult and even impossible without obstructing part of the incoming beam. However, if only a portion of the parabolic surface is used, the beam will focus off-axis at a more accessible location, as shown in Fig. 3. Preferably, the surface of the off-axis parabolic mirror 6 as made of metal.

Fig. 4 shows a tuneable spectrometer 14 with a monochromatic light source module 1 with emits a light beam on a collimation device 5 with an off-axis parabolic mirror 6. Then, the off-axis parabolic mirror 6 reflects a collimated monochromatic light beam 7. Then the collimated monochromatic light beam 7 is redirected by a first deflection mirror 10 on a sample 11, which should be analysed. After passing through the sample 11 the collimated monochromatic light beam 7 is redirected by a second deflection mirror 12 and detected by a detector 13.

State of the art linear stages allow to displace the off-axis parabolic mirror 6 by 100 µm (laser pitch) to a stable new position within less than 50 ms. This prolongs the measurement time for a full spectrum from 1 s to 1.45 s in the case of 10 lasers in operation each operated for 100 ms. This does not increase the response time of the tuneable spectrometer dramatically.

Although the invention has been explained in relation to its preferred embodiments as mentioned above, it is to be understood that many other possible modifications and variations can be made without departing from the scope of the present invention. It is, therefore, contemplated that the appended claim or claims will cover such modifications and variations that fall within the true scope of the invention.

### List of Reference Signs

- 1: Monochromatic light source module
- 2: Array of monochromatic light sources
- 3: First monochromatic light source
- 4: Fourth monochromatic light source
- 5: Collimation device
- 6: Off-axis parabolic mirror
- 7: Collimated monochromatic light beam
- 8: Monochromatic light beam axis
- 9: Direction of off-axis parabolic mirror displacement
- 10: First deflection mirror
- 11: Sample
- 12: Second deflection mirror
- 13: Detector
- 14: Spectrometer

## Claims

1. Optical system, comprising:
- At least two independently switchable monochromatic light sources (3, 4) and
- A collimation device (5) arranged and prepared to collimate the light of the monochromatic light source (3, 4) and to move the focus of the collimation device (5) into the light output facet of the currently active monochromatic light source (3, 4).

2. Optical system according to claim 1, **whereas** the collimation device (5) comprises an off-axis parabolic mirror (5) .

3. Optical system according to one of the previous claims, **whereas** the monochromatic light sources (3, 4) are switchable in a timely consecutive way.

4. Optical system according to one of the previous claims, **whereas** the monochromatic light sources (3, 4) are designed as a laser array.

5. Optical system according to one of the previous claims, **whereas** the collimation device (5) is movable by a linear translation stage.

6. Tuneable laser spectrometer (14) with an optical system according to one of claims 4 or 5, **whereas** the wavelength of the laser is in the infrared range.

7. Method for operating an optical system according to one of claims 1 to 5, **characterized by:**
- A movement of the collimation device (5) along the light output facets of the monochromatic light sources (3, 4) and
- A movement of the collimation device (5), which is synchronized timely with the consecutive emission of the monochromatic light sources (3, 4).
